# EUROPEAN PATENT SPECIFICATION

(11) **EP 3 442 318 B1**
(45) Date of publication and mention of the grant of the patent: **26.05.2021**
(21) Application number: 17778644.9
(22) Date of filing: 05.04.2017
(51) Int. Cl.: H05K 7/20, F04D 27/00, G05D 23/00

(54) **METHOD AND DEVICE FOR REGULATING ROTATIONAL SPEED OF FAN**
VERFAHREN UND VORRICHTUNG ZUM REGELN DER DREHGESCHWINDIGKEIT EINES VENTILATORS
PROCÉDÉ ET DISPOSITIF DE RÉGULATION DE LA VITESSE DE ROTATION D'UN VENTILATEUR

(30) Priority: 08.04.2016 CN 201610219261
(43) Date of publication of application: 13.02.2019
(73) Proprietor: ZTE Corporation, Shenzhen, Guangdong 518057 (CN)
(72) Inventor: ZHANG, Chao, Shenzhen Guangdong 518057 (CN)
(74) Representative: Aipex B.V.
(86) International application number: PCT/CN2017/079459
(87) International publication number: WO 2017/173980

(56) References cited:
- CN-A- 101 109 982
- CN-A- 101 639 077
- CN-A- 101 662 922
- CN-A- 101 739 104
- CN-A- 102 736 709
- CN-A- 103 075 360
- CN-A- 105 402 148
- US-A1- 2006 266 510
- US-A1- 2014 198 451
- US-A1- 2015 192 139
- US-B2- 7 573 708

## Description

### Technical Field

The present disclosure relates, but is not limited, to the field of communications, and in particular to a method and device for regulating a rotational speed of a fan in a communication device.

### Background

A fan, as a common heat dissipation device in a communication device, may dramatically lower the temperature of components such as a high-speed chip. Most methods for regulating a rotational speed of a fan are to regulate the rotational speed of the fan based on the temperature. Regulating the rotational speed of the fan according to the temperature may reduce a power consumption of the fan to some extent. When the temperature is low, the fan runs slowly, so the power consumption is low. When the temperature is high, the fan runs faster to lower the temperature rapidly.

At present, the rotational speed of the fan is automatically regulated usually based on a uniform temperature. However, since heat-resistant properties of different components are very different, and design structures of the fan are different, when the uniform temperature is set high, an effect of overheat protection may not be achieved aiming at the component with poor heat resistant; and when the uniform temperature is set low, the power consumption of the fan is wasted aiming at the component with excellent heat resistant. Further relevant technologies are also known from US 2015/192139 A1 (YAMAGUCHI ATSUSHI [JP] ET AL) 9 July 2015 (2015-07-09) which relates to information processing apparatus and air volume calculation method.

### Summary

The following is a summary of the theme elaborated in the present application. The summary is not intended to limit the protection scope of the claims.

Embodiments of the present invention provide a method for regulating rotational speeds of fans as defined in the independent claim 1 and a device for regulating rotational speeds of fans as defined in the independent claim 6, which may protect a component with poor heat resistant in the working process of a fan , and reduce a power consumption of the fan. Further improvements are provided in the dependent claims.

Also provided is a method for regulating a rotational speed of a fan provided by the embodiments of the present invention, the fan is configured to lower a temperature of a component which is mounted in a slot of a frame of a communication device, and group the slots according to a predetermined grouping mode to form slot groups. The method includes that:
total demanded air volume data of each slot group is obtained according to temperature control parameter information of each group which is mounted in the slot, and a total demanded air volume single-column matrix is formed based on the total demanded air volume data of each slot group;
rotational speed parameter information of the fan and air supply efficiency data of the fan and the relative slot group are obtained, an air supply efficiency single-column matrix of the fan is formed based on the air supply efficiency data, and an air supply efficiency matrix is formed based on the air supply efficiency single-column matrix of each fan;
air supply volume data of the fan is obtained according to the total demanded air volume single-column matrix and the air supply efficiency matrix; and
the rotational speed of the fan is regulated according to the air supply volume data and the rotational speed parameter information.

In an exemplary embodiment, the act that the total demanded air volume data of each slot group is obtained according to the temperature control parameter information of each group which is mounted in the slot, and the total demanded air volume single-column matrix is formed based on the total demanded air volume data of each slot group includes that:
temperature data of each component mounted in the slot and predetermined warning temperature data are obtained, and air volume cooling efficiency data of the component is obtained;
a difference value between the temperature data and the warning temperature data is calculated;
when the difference value is greater than 0, demanded air volume data of the corresponding component is determined according to the difference value and the air volume cooling efficiency data;
for each slot group, all the components in the slot group are traversed, and the demanded air volume data of each component is obtained;
the demanded air volume data of each component in the slot group is added to obtain the total demanded air volume data of the slot group; and
the total demanded air volume single-column matrix is formed based on the total demanded air volume data of each slot group.

In an exemplary embodiment, that act that the air supply efficiency data of the fan and the relative slot group is obtained, the air supply efficiency single-column matrix of the fan is formed based on the air supply efficiency data, and the air supply efficiency matrix is formed based on the air supply efficiency single-column matrix of each fan includes that:
relative position information of the fan and the relative slot group is obtained, wherein the relative position information includes a relative angle and/or a relative distance;
the relative position information is matched with a predetermined air supply efficiency comparison table to obtain the air supply efficiency data of the fan and the relative slot group;
the air supply efficiency single-column matrix of the fan is formed based on each piece of air supply efficiency data; and
all the fans are traversed, and the air supply efficiency matrix is formed based on the air supply efficiency single-column matrix of each fan.

In an exemplary embodiment, the act that the air supply volume data of the fan is obtained according to the total demanded air volume single-column matrix and the air supply efficiency matrix includes that:
a ratio of the total demanded air volume single-column matrix to the air supply efficiency matrix is calculated, and the air supply volume data of the fan is determined according to the ratio.

In an exemplary embodiment, the act that the rotational speed of the fan is regulated according to the air supply volume data and the rotational speed parameter information includes that:
a model of the fan is determined according to the rotational speed parameter information;
a comparison table of air volume and rotational speed which matches with the fan is determined through the model;
in the comparison table of air volume and rotational speed, the rotational speed data of the fan is determined according to the air supply volume data and the rotational speed parameter information; and
the rotational speed of the fan is regulated according to the rotational speed data.

Also provided is a device for regulating a rotational speed of a fan, which includes: a total demanded air volume matrix obtaining module, an air supply volume matrix obtaining module, an air supply volume data obtaining module, and a fan rotational speed regulating module.

The total demanded air volume matrix obtaining module is configured to obtain the total demanded air volume data of each slot group according to the temperature control parameter information of each group which is mounted in the slot, and form the total demanded air volume single-column matrix based on the total demanded air volume data of each slot group.

The air supply volume matrix obtaining module is configured to obtain the rotational speed parameter information of the fan and the air supply efficiency data of the fan and the relative slot group, form the air supply efficiency single-column matrix of the fan based on the air supply efficiency data, and form the air supply efficiency matrix based on the air supply efficiency single-column matrix of each fan.

The air supply volume data obtaining module is configured to determine the air supply volume data of the fan according to the total demanded air volume single-column matrix and the air supply efficiency matrix.

The fan rotational speed regulating module is configured to regulate the rotational speed of the fan according to the air supply volume data and the rotational speed parameter information.

In an exemplary embodiment, the total demanded air volume matrix obtaining module is configured to:
obtain temperature data of each component mounted in the slot and predetermined warning temperature data, and obtain air volume cooling efficiency data of the component;
calculate the difference value between the temperature data and the warning temperature data;
when the difference value is greater than 0, determine the demanded air volume data of the corresponding component according to the difference value and the air volume cooling efficiency data;
for each slot group, traverse all the components in the slot group, and obtain the demanded air volume data of each component;
add the demanded air volume data of each component in the slot group to obtain the total demanded air volume data of the slot group; and
form the total demanded air volume single-column matrix based on the total demanded air volume data of each slot group.

In an exemplary embodiment, the air supply volume matrix obtaining module is configured to:
obtain the rotational speed parameter information of the fan;
obtain the relative position information of the fan and the relative slot group, wherein the relative position information includes the relative angle and/or the relative distance;
match the relative position information with the predetermined air supply efficiency comparison table to obtain the air supply efficiency data of the fan and the relative slot group;
form the air supply efficiency single-column matrix of the fan based on each piece of air supply efficiency data; and
traverse all the fans, and form the air supply efficiency matrix based on the air supply efficiency single-column matrix of each fan.

In an exemplary embodiment, the air supply volume data obtaining module is configured to:
calculate the ratio of the total demanded air volume single-column matrix to the air supply efficiency matrix, and determine the air supply volume data of the fan according to the ratio.

In an exemplary embodiment, the fan rotational speed regulating module is configured to:
determine a model of the fan according to the rotational speed parameter information; determine, through the model, a comparison table of air volume and rotational speed which matches with the fan; in the comparison table of air volume and rotational speed, determine the rotational speed data of the fan according to the air supply volume data and the rotational speed parameter information; and regulate the rotational speed of the fan according to the rotational speed data.

Compared with a known art, the technical solution provided by the embodiments of the present invention includes that: the total demanded air volume data of each slot group is obtained according to the temperature control parameter information of each component which is mounted in the slot, and the total demanded air volume single-column matrix is formed based on the total demanded air volume data of each slot group; the rotational speed parameter information of the fan and the air supply efficiency data of the fan and the relative slot group are obtained, the air supply efficiency single-column matrix of the fan is formed based on the air supply efficiency data, and the air supply efficiency matrix is formed based on the air supply efficiency single-column matrix of each fan; the air supply volume data of the fan is obtained according to the total demanded air volume single-column matrix and the air supply efficiency matrix; and the rotational speed of the fan is regulated according to the air supply volume data and the rotational speed parameter information. The present invention may automatically regulate the rotational speed of the fan according to different temperatures of components, thereby saving the power consumption of the fan on the basis of protecting the component with poor heat resistant.

Other aspects can be understood after the accompanying drawings and detailed descriptions are read and understood.

### Brief Description of Drawings

FIG. 1 is a flowchart of a method for regulating a rotational speed of a fan according to an embodiment of the present invention.
FIG. 2 is a schematic diagram of function modules of a device for regulating a rotational speed of a fan according to an embodiment of the present invention.
FIG. 3 is a structure diagram of a system for regulating a rotational speed of a fan in an embodiment of the present invention.

### Detailed Description

Embodiments of the present application are elaborated below in combination with the accompanying drawings. It should be noted that the embodiments in the present application and the characteristics in the embodiments may be combined under the condition of no conflicts.

An embodiment of the present invention provides a method for regulating a rotational speed of a fan.

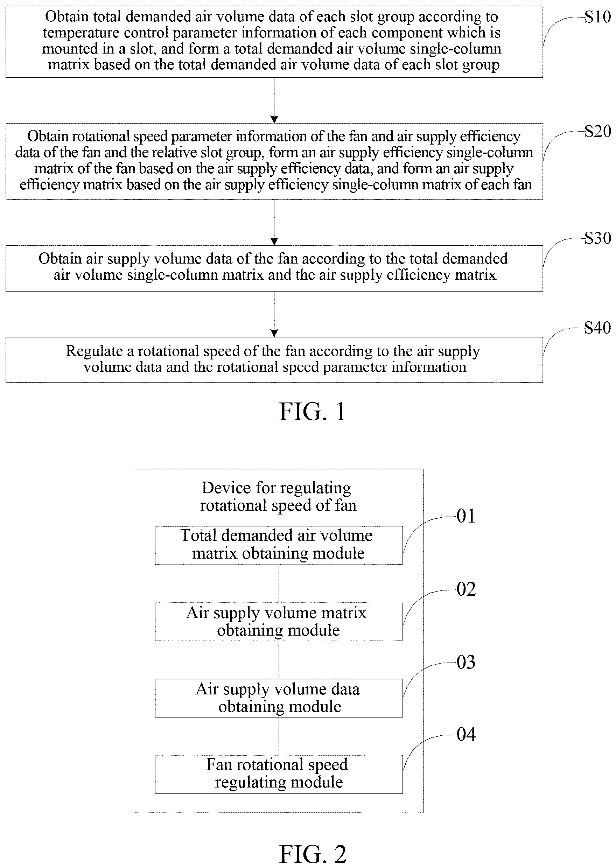

Referring to FIG. 1, it is a flowchart of a method for regulating a rotational speed of a fan according to an embodiment of the present invention.

In an embodiment, the method includes the following steps.

In S10, total demanded air volume data of each slot group is obtained according to temperature control parameter information of each component which is mounted in a slot, and a total demanded air volume single-column matrix is formed based on the total demanded air volume data of each slot group.

Herein, the fan is configured to lower a temperature of the component which is mounted in the slot of a frame of a communication device, and group the slots according to a predetermined grouping mode to form the slot groups. The fan and the slot groups are respectively arranged in the frame of the communication device in a single straight line. The fan includes an independent fan, a fan array, and so on. In an exemplary embodiment, the quantity of independent sub-fans forming a fan array is not limited here. There may be a situation where the quantity of the independent sub-fans and the quantity of the fan arrays are equal to the quantity of the slot groups.

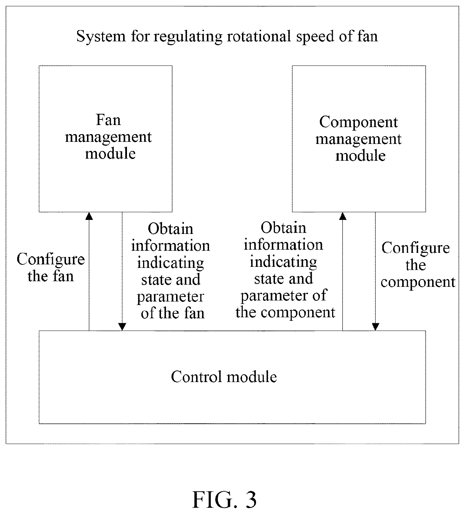

In the present embodiment, the method for regulating a rotational speed of a fan is implemented based on a system for automatically regulating a rotational speed of a fan. As shown in FIG. 3, the structure of the system for regulating a rotational speed of a fan may include a fan management module, a component management module, and a control module.

In an exemplary embodiment, the component management module takes charge of collecting the temperature control parameter information of the corresponding component mounted in the slot, and sending the temperature control parameter information to the control module. The control module calculates the demanded air volume data of the component according to the temperature control parameter information. Herein the temperature control parameter information includes a model of the corresponding component. The component management module traverses the components which are in the same slot group, and sends the temperature control parameter information of the components to the control module to obtain the total demanded air volume data of the slot group. A grouping mode of the slots includes grouping averagely according to the quantity of the slots. In an exemplary embodiment, the grouping mode of the slots is not limited. The slot groups are traversed, the total demanded air volume data of each slot group is obtained, and the total demanded air volume single-column matrix is formed based on the total demanded air volume data of each slot group.

In an embodiment, a calculating mode of the total demanded air volume data includes acquiring the temperature control parameter information of the component with the maximum temperature difference in the same slot group. The temperature control parameter information includes the model of the corresponding component, and the highest temperature of the component maintaining a normal working condition in a theoretical environment. The temperature difference includes a difference value between the existing temperature of the component and the highest temperature of the component maintaining a normal working condition in a theoretical environment. In an exemplary embodiment, when the difference value is greater than or equal to 0, the demanded air volume data in unit time, which causes the temperature of the component to be lowered to a normal working temperature within the specified time, is obtained, and the demanded air volume data is taken as the total demanded air volume data.

In an exemplary embodiment, the required time includes the limit time of the component working normally in a high-temperature environment, and the limit time is not limited here. The normal working temperature includes a normal working temperature obtained according to a match result, herein the match result is obtained by matching the model with predetermined experimental result data. In an exemplary embodiment, the experimental result data includes the temperatures of a variety of components with specific models maintaining a normal working condition in a theoretical environment. The experimental result data is not limited here.

In S20, rotational speed parameter information of the fan and air supply efficiency data of the fan and the relative slot group are obtained, an air supply efficiency single-column matrix of the fan is formed based on the air supply efficiency data, and an air supply efficiency matrix is formed based on the air supply efficiency single-column matrix of each fan.

The rotational speed parameter information of the fan is obtained, herein the rotational speed parameter information includes the model of the fan, and the air supply efficiency data of the fan and the relative slot group is obtained. In an exemplary embodiment, the air supply efficiency data includes air supply volumes in unit time of the fan at different positions. The rotational speed parameter information is obtained by the fan management module and then sent to the control module. The air supply efficiency single-column matrix of the fan is formed with reference to a certain sequence based on the air supply efficiency data. The sequence may include taking the air supply efficiency data of the fan and a slot group at the left end as a first element of the air supply efficiency single-column matrix, and obtaining the elements of the air supply efficiency single-column matrix in order from left to right with reference to the slot groups arranged in a single straight line. The air supply efficiency matrix is formed based on the air supply efficiency single-column matrix of each fan.

In S30, air supply volume data of the fan is obtained according to the total demanded air volume single-column matrix and the air supply efficiency matrix.

The air supply volume data of the corresponding fan is obtained by calculating the ratio of the total demanded air volume single-column matrix to the air supply efficiency matrix.

In an exemplary embodiment, the quantity of the slots is obtained through the component management module, and the quantity of the fans is obtained through the fan management module. The quantity of the slots and the quantity of the fans are sent to the control module. A ratio of the quantity of the slots to the quantity of the fans is calculated by the control module, and the quantity of slot groups is determined according to the ratio. In an exemplary embodiment, when the quantity of the fans is equal to the quantity of the slot groups, the air supply efficiency matrix is a symmetric matrix, and the quantity of rows of the total demanded air volume single-column matrix is equal to the quantity of columns of the air supply efficiency matrix.

In S40, the rotational speed of the fan is regulated according to the air supply volume data and the rotational speed parameter information.

In an exemplary embodiment, the control module determines the rotational speed data of the fan according to the air supply volume data and the rotational speed parameter information of the fan, and sends the rotational speed data to the fan management module. The rotational speed of the fan is regulated by the fan management module.

In an embodiment, the air supply volume data is the air supply volume in unit time of the fan. Since the rotational speed parameter information includes the model of the fan, the model is matched with the predetermined experimental result data, the rotational speed data of the fan is obtained according to the match result. In an exemplary embodiment, the experimental result data includes rotational speed data corresponding to fixed air volumes that a variety of fans with specific models output in unit time in a theoretical environment. The experimental result data is not limited here.

In the present embodiment, the total demanded air volume data of each slot group is obtained according to the temperature control parameter information of the corresponding component which is mounted in the slot, and the total demanded air volume single-column matrix is formed based on the total demanded air volume data of each slot group; the rotational speed parameter information of the fan and the air supply efficiency data of the fan and the relative slot group are obtained, the air supply efficiency single-column matrix of the fan is formed based on the air supply efficiency data, and the air supply efficiency matrix is formed based on the air supply efficiency single-column matrix of each fan; the air supply volume data of the fan is obtained according to the total demanded air volume single-column matrix and the air supply efficiency matrix; and the rotational speed of the fan is regulated according to the air supply volume data and the rotational speed parameter information. Since the present embodiment automatically regulates the rotational speed of the fan more precisely according to the different temperatures of the components, the power consumption of the fan is saved on the basis of protecting the component with poor heat resistant.

In other embodiments, the S10 may include that:
the temperature data of the corresponding component mounted in the slot and the predetermined warning temperature data are obtained, and the air volume cooling efficiency data of the corresponding component is obtained;
a difference value between the temperature data and the warning temperature data is calculated;
when the difference value is greater than 0, the demanded air volume data of the corresponding component is determined according to the difference value and the air volume cooling efficiency data;
for each slot group, all the components in the slot group are traversed, and the demanded air volume data of each component is obtained;
the demanded air volume data of each component in the slot group is added to obtain the total demanded air volume data of the slot group; and
the total demanded air volume single-column matrix is formed based on the total demanded air volume data of each slot group.

In the present embodiment, the temperature data of the corresponding component mounted in the slot and the predetermined warning temperature data are obtained through the component management module, and the air volume cooling efficiency data of the component is obtained. In an exemplary embodiment, the warning temperature data includes the highest temperature of the corresponding component maintaining a normal working condition in a theoretical environment. When the temperature of the corresponding component exceeds the warning temperature data, the difference value between the temperature data and the warning temperature data is calculated, a product of the difference value and the air volume cooling efficiency data is calculated, and the demanded air volume data of the corresponding component is determined according to the product. In an exemplary embodiment, the air volume cooling efficiency data includes data about an air volume required by the corresponding component to lower a unit temperature in unit time. The specific unit of the unit temperature is not limited here.

The components in the same slot group are traversed, the demanded air volume data of the component is obtained, and the demanded air volume data of the component is added to obtain the total demanded air volume data of the slot group. The slot groups are traversed, and the total demanded air volume single-column matrix is formed based on the total demanded air volume data of each slot group. In present embodiment, the air supply efficiencies of the fan to the slot groups in multiple directions are considered on the basis of accurately obtaining the total demanded air volume data of the slot group, and the rotational speed of the fan is regulated accurately according to the air supply efficiency, therefore the power consumption of the fan is saved on the basis of protecting the component with poor heat resistant.

In other embodiments, the S20 may include that:
the rotational speed parameter information of the fan is obtained;
the relative position information of the fan and the relative slot group is obtained, wherein the relative position information includes the relative angle and/or the relative distance;
the relative position information is matched with the predetermined air supply efficiency comparison table to obtain the air supply efficiency data of the fan and the relative slot group;
the air supply efficiency single-column matrix of the fan is formed based on each piece of air supply efficiency data; and
all the fans are traversed, and the air supply efficiency matrix is formed based on the air supply efficiency single-column matrix of each fan.

In the present embodiment, the rotational speed parameter information of the fan is obtained through the fan management module, and the relative position information of the fan and the relative slot group is obtained. The relative position information includes the relative angle and/or the relative distance. In an exemplary embodiment, the relative position information is obtained by establishing a mapping relationship between the fan and the relative slot group through a fan group data structure (EnvFanCtrlGroup). The data structure EnvFanCtrlGroup includes an initial slot number, the quantity of the slots in the present group, and a fan index number. In an exemplary embodiment, composition data of the data structure EnvFanCtrlGroup is not limited here. The relative position information is matched with the predetermined air supply efficiency comparison table to obtain the air supply efficiency data of the fan and the relative slot group. The relative position information is matched with the air supply efficiency comparison table through the fan index number. In an exemplary embodiment, the air supply efficiency comparison table includes the air supply volume in unit time of the fan at different positions, and the different positions are determined through the relative position information. The air supply efficiency single-column matrix of the fan is formed based on each piece of air supply efficiency data.

All the fans are traversed, and the air supply efficiency matrix is formed based on the air supply efficiency single-column matrix of each fan. When the quantity of the fans is equal to the quantity of the slot groups, the air supply efficiency matrix is a symmetric matrix.

In an embodiment, the fan includes a fan array. By calculating a central position of the fan array, the relative position information of the central position and the relative slot group is obtained. The relative position information is matched with the predetermined air supply efficiency comparison table to obtain the air supply efficiency data of the fan array and the relative slot group. The air supply efficiency single-column matrix of the fan is formed based on each piece of air supply efficiency data. The fan array is traversed, and the air supply efficiency matrix is formed based on the air supply efficiency single-column matrix of each fan array, herein the air supply efficiency matrix includes a symmetric air supply efficiency matrix. In present embodiment, the air supply efficiencies of the fan to the slot groups in multiple directions are considered on the basis of accurately obtaining the total demanded air volume data of the slot group, and the rotational speed of the fan is regulated accurately according to the air supply efficiency, therefore the power consumption of the fan is saved on the basis of protecting the component with poor heat resistant.

In other embodiments, the S30 may include that:
a ratio of the total demanded air volume single-column matrix to the air supply efficiency matrix is calculated, and the air supply volume data of the fan is determined according to the ratio.

In the present embodiment, the ratio of the total demanded air volume single-column matrix to the air supply efficiency matrix is calculated, and the air supply volume data of the fan is obtained according to the ratio. In an exemplary embodiment, the data about the air supply volume of the fan may be obtained through the product of the total demanded air volume single-column matrix and an inverse matrix of the air supply efficiency matrix.

In an exemplary embodiment, the quantity of the slots is obtained through the component management module, and the quantity of the fans is obtained through the fan management module. The quantity of the slots and the quantity of the fans are sent to the control module. The ratio of the quantity of the slots to the quantity of the fans is calculated by the control module, and the quantity of the slot groups is determined according to the ratio. In an exemplary embodiment, when the quantity of the fans is equal to the quantity of the slot groups, the air supply efficiency matrix is a symmetric matrix, and the quantity of rows of the total demanded air volume single-column matrix is equal to the quantity of columns of the air supply efficiency matrix.

In an embodiment, when the ratio is an integer, the quantity of the slot groups is directly determined according to the ratio. When the calculation result includes a remainder, with reference to a certain sequence, the single slot is shielded in sequence from left and right ends of the slot queue. After the quantity of the shielded slots is equal to the remainder, the grouping operation is performed on the rest slots. After the grouping operation is completed, the shielded slots at the left and right ends are merged into the slot groups at the left and right ends of the slot group queue. In an exemplary embodiment, the sequence includes left-right-left-right-... or right-left-right-left-..., and in the embodiments of the present invention, the sequence is not limited. In present embodiment, the air supply efficiencies of the fan to the slot groups in multiple directions are considered on the basis of accurately obtaining the total demanded air volume data of the slot group, and the rotational speed of the fan is regulated accurately according to the air supply efficiency, therefore the power consumption of the fan is saved on the basis of protecting the component with poor heat resistant.

In other embodiments, the S40 may include that:
the model of the fan is determined according to the rotational speed parameter information;
the comparison table of air volume and rotational speed which matches with the fan is determined through the model;
in the comparison table of air volume and rotational speed, the rotational speed data of the fan is determined according to the air supply volume data and the rotational speed parameter information; and
the rotational speed of the fan is regulated according to the rotational speed data.

In the present embodiment, the rotational speed parameter information is sent to a control unit module through the fan management module. Since the rotational speed parameter information includes the model of the fan, the comparison table of air volume and rotational speed which matches with the fan is determined through the model. In an exemplary embodiment, the experimental result data includes rotational speed data corresponding to fixed air volumes that a variety of fans with specific models output in unit time in a theoretical environment. The experimental result data is not limited here. The corresponding rotational speed data is sent to the fan management module, and the rotational speed of the fan is regulated by the fan management module according to the rotational speed data. In present embodiment, the air supply efficiencies of the fan to the slot groups in multiple directions are considered on the basis of accurately obtaining the total demanded air volume data of the slot group, and the rotational speed of the fan is regulated accurately according to the air supply efficiency, therefore the power consumption of the fan is saved on the basis of protecting the component with poor heat resistant.

An embodiment of the present invention also provides a computer storage medium storing computer-executable instructions. The computer-executable instructions are used for implementing the method for regulating a rotational speed of a fan.

An embodiment of the present invention also provides a device for regulating a rotational speed of a fan, which includes: a storage and a processor.

The processor is configured to execute program instructions in the storage.

The program instructions are read in the processor to perform the following acts:
the total demanded air volume data of each slot group is obtained according to temperature control parameter information of each component which is mounted in a slot, and the total demanded air volume single-column matrix is formed based on the total demanded air volume data of each slot group;
the rotational speed parameter information of the fan and the air supply efficiency data of the fan and the relative slot group are obtained, the air supply efficiency single-column matrix of the fan is formed based on the air supply efficiency data, and the air supply efficiency matrix is formed based on the air supply efficiency single-column matrix of each fan;
the air supply volume data of the fan is obtained according to the total demanded air volume single-column matrix and the air supply efficiency matrix; and
the rotational speed of the fan is regulated according to the air supply volume data and the rotational speed parameter information.

Herein, the fan is configured to lower a temperature of the component which is mounted in the slot of the frame of the communication device, and group the slots according to the predetermined grouping mode to form the slot groups.

The present invention further provides a device for regulating a rotational speed of a fan.

Referring to FIG. 2, it is a schematic diagram of function modules of the device for regulating a rotational speed of a fan according to in an embodiment of the present invention.

In an embodiment, the device for regulating a rotational speed of a fan may include: a total demanded air volume matrix obtaining module 01, an air supply volume matrix obtaining module 02, an air supply volume data obtaining module 03, and a fan rotational speed regulating module 04.

The total demanded air volume matrix obtaining module 01 is configured to obtain the total demanded air volume data of each slot group according to the temperature control parameter information of each component which is mounted in a slot, and form the total demanded air volume single-column matrix based on the total demanded air volume data of each slot group.

In a practical application, the device for regulating a rotational speed of a fan in the present embodiment may implement, through the system for regulating a rotational speed of a fan, a function of regulating the rotational speed of the fan. As shown in FIG. 3, the structure of the system for regulating a rotational speed of a fan may include: a fan management module, a component management module, and a control unit module. The fan management module may include the fan rotational speed regulating module 04 in the present embodiment. The component management module may include the total demanded air volume matrix obtaining module 01 in the present embodiment. The control unit module may include the air supply volume matrix obtaining module 02 and the air supply volume data obtaining module 03 in the present embodiment.

The component management module takes charge of collecting the temperature control parameter information of the corresponding component mounted in the slot, and sending the temperature control parameter information to the control module. The control module calculates the demanded air volume data of the component according to the temperature control parameter information. Herein the temperature control parameter information includes a model of the corresponding component. The component management module traverses the components which are in the same slot group, and sends the temperature control parameter information of the components to the control module to obtain the total demanded air volume data of the slot group. A grouping mode of the slots includes grouping averagely according to the quantity of the slots. In an exemplary embodiment, the grouping mode of the slots is not limited. The slot groups are traversed, the total demanded air volume data of each slot group is obtained, and the total demanded air volume single-column matrix is formed based on the total demanded air volume data of each slot group.

In an embodiment, a calculating mode of the total demanded air volume data includes selecting the temperature control parameter information of the component with the maximum temperature difference in the same slot group. The temperature control parameter information includes the model of the corresponding component and the highest temperature of the component maintaining a normal working condition in a theoretical environment. The temperature difference includes a difference value between the existing temperature of the component and the highest temperature of the component maintaining a normal working condition in a theoretical environment. In an exemplary embodiment, when the difference value is greater than or equal to 0, the demanded air volume data in unit time, which causes the temperature of the component to be lowered to the normal working temperature within the specified time, is obtained, and the demanded air volume data is taken as the total demanded air volume data.

In an exemplary embodiment, the required time includes the limit time of the component working normally in a high-temperature environment, and the limit time is not limited here. The normal working temperature includes a normal working temperature obtained according to a match result, herein the match result is obtained by matching the model with predetermined experimental result data. In an exemplary embodiment, the experimental result data includes the temperatures of a variety of components with specific models maintaining a normal working condition in a theoretical environment. The experimental result data is not limited here.

The air supply volume matrix obtaining module 02 is configured to obtain the rotational speed parameter information of the fan and the air supply efficiency data of the fan and the relative slot group, form an air supply efficiency single-column matrix of the fan based on the air supply efficiency data, and form an air supply efficiency matrix based on the air supply efficiency single-column matrix of each fan.

The rotational speed parameter information of the fan is obtained, herein the rotational speed parameter information includes the model of the fan, and the air supply efficiency data of the fan and the relative slot group is obtained. In an exemplary embodiment, the air supply efficiency data includes the air supply volumes in unit time of the fan at different positions. The rotational speed parameter information is obtained by the fan management module and then sent to the control module. The air supply efficiency single-column matrix of the fan is formed with reference to a certain sequence based on the air supply efficiency data. The sequence may include taking the air supply efficiency data of the fan and a slot group at the left end as a first element of the air supply efficiency single-column matrix, and obtaining the elements of the air supply efficiency single-column matrix in order from left to right with reference to the slot groups arranged in a single straight line. The air supply efficiency matrix is formed based on the air supply efficiency single-column matrix of each fan.

The air supply volume data obtaining module 03 is configured to obtain air supply volume data of the fan according to the total demanded air volume single-column matrix and the air supply efficiency matrix.

The air supply volume data obtaining module 03 is configured to obtain the air supply volume data of the corresponding fan by calculating a ratio of the total demanded air volume single-column matrix to the air supply efficiency matrix.

In an exemplary embodiment, the quantity of the slots is obtained through the component management module, and the quantity of the fans is obtained through the fan management module. The quantity of the slots and the quantity of the fans are sent to the control module. A ratio of the quantity of the slots to the quantity of the fans is calculated by the control module, and the quantity of slot groups is determined according to the ratio. In an exemplary embodiment, when the quantity of the fans is equal to the quantity of the slot groups, the air supply efficiency matrix is a symmetric matrix, and the quantity of rows of the total demanded air volume single-column matrix is equal to the quantity of columns of the air supply efficiency matrix.

The fan rotational speed regulating module 04 is configured to regulate a rotational speed of the fan according to the air supply volume data and the rotational speed parameter information.

The control module determines the rotational speed data of the fan according to the air supply volume data and the rotational speed parameter information of the fan, and sends the rotational speed data to the fan management module. The rotational speed of the fan is regulated by the fan management module.

In an embodiment, the air supply volume data is the air supply volume in unit time of the fan. Since the rotational speed parameter information includes the model of the fan, the model is matched with the predetermined experimental result data, the rotational speed data of the fan is obtained according to the match result. In an exemplary embodiment, the experimental result data includes rotational speed data corresponding to fixed air volumes that a variety of fans with specific models output in unit time in a theoretical environment. The experimental result data is not limited here.

In the present embodiment, the total demanded air volume data of the slot group is obtained according to the temperature control parameter information of the corresponding component which is mounted in the slot, and the total demanded air volume single-column matrix is formed based on the total demanded air volume data of each slot group; the rotational speed parameter information of the fan and the air supply efficiency data of the fan and the relative slot group are obtained, the air supply efficiency single-column matrix of the fan is formed based on the air supply efficiency data, and the air supply efficiency matrix is formed based on the air supply efficiency single-column matrix of each fan; the air supply volume data of the fan is obtained according to the total demanded air volume single-column matrix and the air supply efficiency matrix; and the rotational speed of the fan is regulated according to the air supply volume data and the rotational speed parameter information. Since the present embodiment automatically regulates the rotational speed of the fan more precisely according to the different temperatures of the components, the power consumption of the fan is saved on the basis of protecting the component with poor heat resistant.

In other embodiments, the total demanded air volume matrix obtaining module 01 may be configured to:
in the present embodiment, obtain the temperature data of the corresponding component mounted in the slot and the predetermined warning temperature data through the component management module, and obtain the air volume cooling efficiency data of the component. In an exemplary embodiment, the warning temperature data includes the highest temperature of the corresponding component maintaining a normal working condition in a theoretical environment. The total demanded air volume matrix obtaining module 01 may be configured to, when the temperature of the corresponding component exceeds the warning temperature data, calculate the difference value between the temperature data and the warning temperature data, calculate the product of the difference value and the air volume cooling efficiency data, and determine the demanded air volume data of the corresponding component according to the product. In an exemplary embodiment, the air volume cooling efficiency data includes the data about the air volume required by the corresponding component to lower the unit temperature in unit time, and the specific unit of the unit temperature is not limited here.

In an exemplary embodiment, the total demanded air volume matrix obtaining module 01 may be configured to traverse the components in the same slot group, obtain the demanded air volume data of the component, and add the demanded air volume data of the component to obtain the total demanded air volume data of the slot group; and traverse the slot groups, and form the total demanded air volume single-column matrix based on the total demanded air volume data of each slot group. In present embodiment, the air supply efficiencies of the fan to the slot groups in multiple directions are considered on the basis of accurately obtaining the total demanded air volume data of the slot group, and the rotational speed of the fan is regulated accurately according to the air supply efficiency, therefore the power consumption of the fan is saved on the basis of protecting the component with poor heat resistant.

In other embodiments, the air supply volume matrix obtaining module 02 may be configured to:
obtain the rotational speed parameter information of the fan; obtain the relative position information of the fan and the relative slot group, wherein the relative position information includes the relative angle and/or the relative distance; match the relative position information with the predetermined air supply efficiency comparison table to obtain the air supply efficiency data of the fan and the relative slot group; form the air supply efficiency single-column matrix of the fan based on each piece of air supply efficiency data; and traverse all the fans, and form the air supply efficiency matrix based on the air supply efficiency single-column matrix of each fan.

In the present embodiment, the rotational speed parameter information of the fan is obtained through the fan management module, and the relative position information of the fan and the relative slot group is obtained. Herein the relative position information includes the relative angle and/or the relative distance. In an exemplary embodiment, the relative position information is obtained by establishing a mapping relationship between the fan and the relative slot group through the data structure EnvFanCtrlGroup. The data structure EnvFanCtrlGroup includes an initial slot number, the quantity of the slots in the present group, and a fan index number. Particularly, the composition data of the data structure EnvFanCtrlGroup is not limited here. The relative position information is matched with the predetermined air supply efficiency comparison table to obtain the air supply efficiency data of the fan and the relative slot group. The relative position information is matched with the air supply efficiency comparison table through the fan index number. In an exemplary embodiment, the air supply efficiency comparison table includes the air supply volume in unit time of the fan at different positions, and the different positions are determined through the relative position information. The air supply efficiency single-column matrix of the fan is formed based on each piece of air supply efficiency data.

All the fans are traversed, and the air supply efficiency matrix is formed based on the air supply efficiency single-column matrix of each fan. When the quantity of the fans is equal to the quantity of the slot groups, the air supply efficiency matrix is a symmetric matrix.

In an embodiment, the fan includes a fan array. By calculating a central position of the fan array, the relative position information of the central position and the relative slot group is obtained. The relative position information is matched with the predetermined air supply efficiency comparison table to obtain the air supply efficiency data of the fan array and the relative slot group. The air supply efficiency single-column matrix of the fan is formed based on each piece of air supply efficiency data. The fan array is traversed, and the air supply efficiency matrix is formed based on the air supply efficiency single-column matrix of each fan array, herein the air supply efficiency matrix includes the symmetric air supply efficiency matrix. In present embodiment, the air supply efficiencies of the fan to the slot groups in multiple directions are considered on the basis of accurately obtaining the total demanded air volume data of the slot group, and the rotational speed of the fan is regulated accurately according to the air supply efficiency, therefore the power consumption of the fan is saved on the basis of protecting the component with poor heat resistant.

In other embodiments, the air supply volume matrix obtaining module 03 may be configured to:
calculate a ratio of the total demanded air volume single-column matrix to the air supply efficiency matrix, and determine the air supply volume data of the fan according to the ratio.

In the present embodiment, the ratio of the total demanded air volume single-column matrix to the air supply efficiency matrix is calculated, and the air supply volume data of the fan is obtained according to the ratio. In an exemplary embodiment, the data about the air supply volume of the fan may be obtained through the product of the total demanded air volume single-column matrix and the inverse matrix of the air supply efficiency matrix.

In an exemplary embodiment, the quantity of the slots is obtained through the component management module, and the quantity of the fans is obtained through the fan management module. The quantity of the slots and the quantity of the fans are sent to the control module. The ratio of the quantity of the slots to the quantity of the fans is calculated by the control module, and the quantity of the slot groups is determined according to the ratio. In an exemplary embodiment, when the quantity of the fans is equal to the quantity of the slot groups, the air supply efficiency matrix is the symmetric matrix, and the quantity of rows of the total demanded air volume single-column matrix is equal to the quantity of columns of the air supply efficiency matrix.

In an embodiment, when the ratio is an integer, the quantity of the slot groups is directly determined according to the ratio. When the calculation result includes a remainder, with reference to a certain sequence, the single slot is shielded in sequence from left and right ends of the slot queue. After the quantity of the shielded slots is equal to the remainder, the grouping operation is performed on the rest slots. After the grouping operation is completed, the shielded slots at the left and right ends are merged into the slot groups at the left and right ends of the slot group queue. In an exemplary embodiment, the sequence includes left-right-left-right-... or right-left-right-left-..., and in the embodiments of the present invention, the sequence is not limited. In present embodiment, the air supply efficiencies of the fan to the slot groups in multiple directions are considered on the basis of accurately obtaining the total demanded air volume data of the slot group, and the rotational speed of the fan is regulated accurately according to the air supply efficiency, therefore the power consumption of the fan is saved on the basis of protecting the component with poor heat resistant.

In other embodiments, the fan rotational speed regulating module 04 may be configured to:
determine the model of the fan according to the rotational speed parameter information; determine, through the model, the comparison table of air volume and rotational speed which matches with the fan; in the comparison table of air volume and rotational speed, determine the rotational speed data of the fan according to the air supply volume data and the rotational speed parameter information; and regulate the rotational speed of the fan according to the rotational speed data.

In the present embodiment, the rotational speed parameter information is sent to a control unit module through the fan management module. Since the rotational speed parameter information includes the model of the fan, the comparison table of air volume and rotational speed which matches with the fan is determined through the model. In an exemplary embodiment, the experimental result data includes rotational speed data corresponding to fixed air volumes that a variety of fans with specific models output in unit time in a theoretical environment. The experimental result data is not limited here. The corresponding rotational speed data is sent to the fan management module, and the rotational speed of the fan is regulated by the fan management module according to the rotational speed data. In present embodiment, the air supply efficiencies of the fan to the slot groups in multiple directions are considered on the basis of accurately obtaining the total demanded air volume data of the slot group, and the rotational speed of the fan is regulated accurately according to the air supply efficiency, therefore the power consumption of the fan is saved on the basis of protecting the component with poor heat resistant.

Those of ordinary skill in the art may understand that all or part of the steps in the method may be performed by related hardware (for example, a processor) instructed through a program. The program may be stored in computer readable storage medium, such as a read-only memory, a magnetic disk or a compact disk. In an exemplary, all or part of the steps of the embodiments may also be implemented by using one or more integrated circuits Correspondingly, each module/unit in the embodiments may be implemented in the form of hardware, for example, its corresponding function is implemented through an integrated circuit, or in the form of software function module, for example, its corresponding function is implemented by executing programs/instructions stored in a storage through a processor. The present invention is not limited to any particular combination of hardware and software.

Although the embodiments disclosed by the present application arc as above, the contents, for example, the specific implementation modes in the embodiments of the present invention, are the implementations only adopted for facilitating understanding, but not intended to limit the present application. Any skilled in the art of the present application may make any modification and change on implementation forms and details without departing from the scope of the invention which is solely defined by the claims attached.

### Industrial Applicability

The above technical solution may automatically regulate a rotational speed of a fan, thereby saving the power consumption of the fan on the basis of protecting a component with poor heat resistant.

## Claims

1. A method for regulating rotational speeds of fans, wherein the fans are configured to lower temperatures of components which are mounted in slots of a frame of a communication device correspondingly, and the slots are grouped according to a predetermined grouping mode to form slot groups; the method comprising:
obtaining (S10) total demanded air volume data of each slot group according to temperature control parameter information of each component which is mounted in the corresponding slot, and forming a total demanded air volume single-column matrix based on the total demanded air volume data of each slot group;
obtaining (S20) rotational speed parameter information of each fan and air supply efficiency data of each fan to each slot group, forming an air supply efficiency single-column matrix of each fan based on the air supply efficiency data of the each fan to each slot group, and forming an air supply efficiency matrix based on the air supply efficiency single-column matrix of each fan;
obtaining (S30) air supply volume data of each fan according to the total demanded air volume single-column matrix and the air supply efficiency matrix; and
regulating (S40) the rotational speed of each fan according to the air supply volume data of the each fan and the rotational speed parameter information of the each fan.

2. The method according to claim 1, wherein the obtaining total demanded air volume data of each slot group according to temperature control parameter information of each component which is mounted in the corresponding slot, and forming a total demanded air volume single-column matrix based on the total demanded air volume data of each slot group comprises:
obtaining temperature data of each component mounted in each slot and predetermined warning temperature data, and obtaining air volume cooling efficiency data of the component;
calculating a difference value between the temperature data and the warning temperature data;
when the difference value is greater than 0, determining demanded air volume data of the corresponding component according to the difference value and the air volume cooling efficiency data;
for each slot group, traversing all components in the slot group, and obtaining demanded air volume data of each component;
adding the demanded air volume data of each component in the slot group to obtain the total demanded air volume data of the slot group; and
forming the total demanded air volume single-column matrix based on the total demanded air volume data of each slot group.

3. The method according to claim 1, wherein the obtaining air supply efficiency data of each fan to each slot group, forming an air supply efficiency single-column matrix of the fan based on the air supply efficiency data of the each fan to each slot group, and forming an air supply efficiency matrix based on the air supply efficiency single-column matrix of each fan comprises:
obtaining relative position information of each fan and each slot group, wherein the relative position information comprises a relative angle and/or a relative distance;
matching the relative position information with a predetermined air supply efficiency comparison table to obtain the air supply efficiency data of each fan to each slot group;
forming the air supply efficiency single-column matrix of each fan based on the air supply efficiency data of the each fan to each slot group; and
traversing all fans, and forming the air supply efficiency matrix based on the air supply efficiency single-column matrix of each fan.

4. The method according to claim 1, wherein the obtaining air supply volume data of each fan according to the total demanded air volume single-column matrix and the air supply efficiency matrix comprises:
calculating a ratio of the total demanded air volume single-column matrix to the air supply efficiency matrix, and determining the air supply volume data of each fan according to the ratio.

5. The method according to any one of claims 1 to 4, wherein the regulating the rotational speed of each fan according to the air supply volume data of the each fan and the rotational speed parameter information of the each fan comprises:
determining a model of each fan according to the rotational speed parameter information of the each fan;
determining, through the model of each fan, a comparison table of air volume and rotational speed which matches with the each fan;
determining rotational speed data of each fan through the comparison table of air volume and rotational speed according to the air supply volume data of the each fan and the rotational speed parameter information of the each fan; and
regulating the rotational speed of each fan according to the rotational speed data of the each fan.

6. A device for regulating rotational speeds of fans, comprising:
a total demanded air volume matrix obtaining module (01), configured to obtain total demanded air volume data of each slot group according to temperature control parameter information of each component which is mounted in the corresponding slot, and form a total demanded air volume single-column matrix based on the total demanded air volume data of each slot group;
an air supply volume matrix obtaining module (02), configured to obtain rotational speed parameter information of each fan and air supply efficiency data of each fan to each slot group, form an air supply efficiency single-column matrix of each fan based on the air supply efficiency data of the each fan to each slot group, and form an air supply efficiency matrix based on the air supply efficiency single-column matrix of each fan;
an air supply volume data obtaining module (03), configured to determine air supply volume data of each fan according to the total demanded air volume single-column matrix and the air supply efficiency matrix; and
a fan rotational speed regulating module (04), configured to regulate a rotational speed of each fan according to the air supply volume data of the each fan and the rotational speed parameter information of the each fan.

7. The device according to claim 6, wherein the total demanded air volume matrix obtaining module is configured to:
obtain temperature data of each component mounted in each slot and predetermined warning temperature data, and obtain air volume cooling efficiency data of the component;
calculate a difference value between the temperature data and the warning temperature data;
when the difference value is greater than 0, determine demanded air volume data of the corresponding component according to the difference value and the air volume cooling efficiency data;
for each slot group, traverse all components in the slot group, and obtain the demanded air volume data of each component;
add the demanded air volume data of each component in the slot group to obtain the total demanded air volume data of the slot group; and
form the total demanded air volume single-column matrix based on the total demanded air volume data of each slot group.

8. The device according to claim 6, wherein the air supply volume matrix obtaining module is configured to:
obtain the rotational speed parameter information of the fan;
obtain relative position information of each fan and each slot group, wherein the relative position information comprises a relative angle and/or a relative distance;
match the relative position information with a predetermined air supply efficiency comparison table to obtain the air supply efficiency data of each fan to each slot group;
form the air supply efficiency single-column matrix of each fan based on the air supply efficiency data of the each fan to each slot group; and
traverse all fans, and form the air supply efficiency matrix based on the air supply efficiency single-column matrix of each fan.

9. The device according to claim 6, wherein the air supply volume data obtaining module is configured to:
calculate a ratio of the total demanded air volume single-column matrix to the air supply efficiency matrix, and determine the air supply volume data of each fan according to the ratio.

10. The device according to any one of claims 6-9, wherein the fan rotational speed regulating module is configured to:
determine a model of each fan according to the rotational speed parameter information of the each fan; determining, through the model of each fan, a comparison table of air volume and rotational speed which matches with the each fan; determine rotational speed data of each fan through the comparison table of air volume and rotational speed according to the air supply volume data of the each fan and the rotational speed parameter information of the each fan; and
regulate the rotational speed of the fan according to the rotational speed data.

11. A computer-readable storage medium, storing computer-executable instructions, which, when being executed on a fan rotational speed regulating module of a device for regulating rotational speeds of fans according to claim 6, implements the method for regulating rotational speeds of fans of claim 1.

## Patentansprüche

1. Verfahren zum Regeln von Drehgeschwindigkeiten von Ventilatoren, wobei die Ventilatoren dazu konfiguriert sind, Temperaturen von Komponenten, die in Schlitzen eines Rahmens einer Kommunikationsvorrichtung montiert sind, entsprechend zu senken, und die Schlitze gemäß einem vorbestimmten Gruppierungsmodus gruppiert sind, um Schlitzgruppen zu bilden; wobei das Verfahren Folgendes umfasst:
Erlangen (S10) von Daten zum gesamten geforderten Luftvolumen jeder Schlitzgruppe gemäß Temperatursteuerparameterinformationen jeder Komponente, die in dem entsprechenden Schlitz montiert ist, und Bilden einer einspaltigen Matrix zum gesamten geforderten Luftvolumen auf Grundlage der Daten zum gesamten geforderten Luftvolumen jeder Schlitzgruppe;
Erlangen (S20) von Drehgeschwindigkeitsparameterinformationen jedes Ventilators und Daten zur Luftzufuhreffizienz jedes Ventilators zu jeder Schlitzgruppe, Bilden einer einspaltigen Matrix zur Luftzufuhreffizienz jedes Ventilators auf Grundlage der Daten zur Luftzufuhreffizienz des jeden Ventilators zu jeder Schlitzgruppe und Bilden einer Matrix zur Luftzufuhreffizienz auf Grundlage der einspaltigen Matrix zur Luftzufuhreffizienz jedes Ventilators;
Erlangen (S30) von Daten zum Luftzufuhrvolumen jedes Ventilators gemäß der einspaltigen Matrix zum gesamten geforderten Luftvolumen und der Matrix zur Luftzufuhreffizienz; und
Regeln (S40) der Drehgeschwindigkeit jedes Ventilators gemäß den Daten zum Luftzufuhrvolumen des jeden Ventilators und den Drehgeschwindigkeitsparameterinformationen des jeden Ventilators.

2. Verfahren nach Anspruch 1, wobei das Erlangen von Daten zum gesamten geforderten Luftvolumen jeder Schlitzgruppe gemäß Temperatursteuerparameterinformationen jeder Komponente, die in dem entsprechenden Schlitz montiert ist, und Bilden einer einspaltigen Matrix zum gesamten geforderten Luftvolumen auf Grundlage der Daten zum gesamten geforderten Luftvolumen jeder Schlitzgruppe Folgendes umfasst:
Erlangen von Temperaturdaten jeder Komponente, die in jedem Schlitz montiert ist, und vorbestimmten Warnungstemperaturdaten und Erlangen von Daten zur Luftvolumenkühleffizienz der Komponente;
Berechnen eines Differenzwerts zwischen den Temperaturdaten und den Warnungstemperaturdaten;
wenn der Differenzwert größer als 0 ist, Bestimmen von Daten zum geforderten Luftvolumen der entsprechenden Komponente gemäß dem Differenzwert und den Daten zur Luftvolumenkühleffizienz;
für jede Schlitzgruppe Durchlaufen aller Komponenten in der Schlitzgruppe und Erlangen von Daten zum geforderten Luftvolumen jeder Komponente;
Addieren der Daten zum geforderten Luftvolumen jeder Komponente in der Schlitzgruppe, um die Daten zum gesamten geforderten Luftvolumen der Schlitzgruppe zu erlangen; und
Bilden der einspaltigen Matrix zum gesamten geforderten Luftvolumen auf Grundlage der Daten zum gesamten geforderten Luftvolumen jeder Schlitzgruppe.

3. Verfahren nach Anspruch 1, wobei das Erlangen von Daten zur Luftzufuhreffizienz jedes Ventilators zu jeder Schlitzgruppe, Bilden einer einspaltigen Matrix zur Luftzufuhreffizienz des Ventilators auf Grundlage der Daten zur Luftzufuhreffizienz des jeden Ventilators zu jeder Schlitzgruppe und Bilden einer Matrix zur Luftzufuhreffizienz auf Grundlage der einspaltigen Matrix zur Luftzufuhreffizienz jedes Ventilators Folgendes umfasst:
Erlangen von relativen Positionsinformationen jedes Ventilators und jeder Schlitzgruppe, wobei die relativen Positionsinformationen einen relativen Winkel und/oder einen relativen Abstand umfassen;
Abgleichen der relativen Positionsinformationen mit einer vorbestimmten Vergleichstabelle zur Luftzufuhreffizienz, um die Daten zur Luftzufuhreffizienz jedes Ventilators zu jeder Schlitzgruppe zu erlangen;
Bilden der einspaltigen Matrix zur Luftzufuhreffizienz jedes Ventilators auf Grundlage der Daten zur Luftzufuhreffizienz des jeden Ventilators zu jeder Schlitzgruppe; und
Durchlaufen aller Ventilatoren und Bilden der Matrix zur Luftzufuhreffizienz auf Grundlage der einspaltigen Matrix zur Luftzufuhreffizienz jedes Ventilators.

4. Verfahren nach Anspruch 1, wobei das Erlangen von Daten zum Luftzufuhrvolumen jedes Ventilators gemäß der einspaltigen Matrix zum gesamten geforderten Luftvolumen und der Matrix zur Luftzufuhreffizienz Folgendes umfasst:
Berechnen eines Verhältnisses der einspaltigen Matrix zum gesamten geforderten Luftvolumen zu der Matrix zur Luftzufuhreffizienz und Bestimmen der Daten zum Luftzufuhrvolumen jedes Ventilators gemäß dem Verhältnis.

5. Verfahren nach einem der Ansprüche 1 bis 4, wobei das Regeln der Drehgeschwindigkeit jedes Ventilators gemäß den Daten zum Luftzufuhrvolumen des jeden Ventilators und den Drehgeschwindigkeitsparameterinformationen des jeden Ventilators Folgendes umfasst:
Bestimmen eines Modells jedes Ventilators gemäß den Drehgeschwindigkeitsparameterinformationen des jeden Ventilators;
Bestimmen einer Vergleichstabelle von Luftvolumen und Drehgeschwindigkeit durch das Modell jedes Ventilators, die mit dem jeden Ventilator abgeglichen wird;
Bestimmen von Daten zur Drehgeschwindigkeit jedes Ventilators durch die Vergleichstabelle von Luftvolumen und Drehgeschwindigkeit gemäß den Daten zum Luftzufuhrvolumen des jeden Ventilators und den Drehgeschwindigkeitsparameterinformationen des jeden Ventilators; und
Regeln der Drehgeschwindigkeit jedes Ventilators gemäß den Daten zur Drehgeschwindigkeit des jeden Ventilators.

6. Vorrichtung zum Regeln von Drehgeschwindigkeiten von Ventilatoren, umfassend:
ein Modul (01) zum Erlangen einer Matrix zum gesamten geforderten Luftvolumen, das konfiguriert ist zum Erlangen von Daten zum gesamten geforderten Luftvolumen jeder Schlitzgruppe gemäß Temperatursteuerparameterinformationen jeder Komponente, die in dem entsprechenden Schlitz montiert ist, und Bilden einer einspaltigen Matrix zum gesamten geforderten Luftvolumen auf Grundlage der Daten zum gesamten geforderten Luftvolumen jeder Schlitzgruppe;
ein Modul (02) zum Erlangen einer Matrix zum Luftzufuhrvolumen, das konfiguriert ist zum Erlangen von Drehgeschwindigkeitsparameterinformationen jedes Ventilators und Daten zur Luftzufuhreffizienz jedes Ventilators zu jeder Schlitzgruppe, Bilden einer einspaltigen Matrix zur Luftzufuhreffizienz jedes Ventilators auf Grundlage der Daten zur Luftzufuhreffizienz des jeden Ventilators zu jeder Schlitzgruppe und Bilden einer Matrix zur Luftzufuhreffizienz auf Grundlage der einspaltigen Matrix zur Luftzufuhreffizienz jedes Ventilators;
ein Modul (03) zum Erlangen von Daten zum Luftzufuhrvolumen, das konfiguriert ist zum Bestimmen von Daten zum Luftzufuhrvolumen jedes Ventilators gemäß der einspaltigen Matrix zum gesamten geforderten Luftvolumen und der Matrix zur Luftzufuhreffizienz; und
ein Modul (04) zum Regeln einer Drehgeschwindigkeit eines Ventilators, das konfiguriert ist zum Regeln einer Drehgeschwindigkeit jedes Ventilators gemäß den Daten zum Luftzufuhrvolumen des jeden Ventilators und den Drehgeschwindigkeitsparameterinformationen des jeden Ventilators.

7. Vorrichtung nach Anspruch 6, wobei das Modul zum Erlangen einer Matrix zum gesamten geforderten Luftvolumen zu Folgendem konfiguriert ist:
Erlangen von Temperaturdaten jeder Komponente, die in jedem Schlitz montiert ist, und vorbestimmten Warnungstemperaturdaten und Erlangen von Daten zur Luftvolumenkühleffizienz der Komponente;
Berechnen eines Differenzwerts zwischen den Temperaturdaten und den Warnungstemperaturdaten;
wenn der Differenzwert größer als 0 ist, Bestimmen von Daten zum geforderten Luftvolumen der entsprechenden Komponente gemäß dem Differenzwert und den Daten zur Luftvolumenkühleffizienz;
für jede Schlitzgruppe Durchlaufen aller Komponenten in der Schlitzgruppe und Erlangen der Daten zum geforderten Luftvolumen jeder Komponente;
Addieren der Daten zum geforderten Luftvolumen jeder Komponente in der Schlitzgruppe, um die Daten zum gesamten geforderten Luftvolumen der Schlitzgruppe zu erlangen; und
Bilden der einspaltigen Matrix zum gesamten geforderten Luftvolumen auf Grundlage der Daten zum gesamten geforderten Luftvolumen jeder Schlitzgruppe.

8. Vorrichtung nach Anspruch 6, wobei das Modul zum Erlangen einer Matrix zum Luftzufuhrvolumen zu Folgendem konfiguriert ist:
Erlangen der Drehgeschwindigkeitsparameterinformationen des Ventilators;
Erlangen von relativen Positionsinformationen jedes Ventilators und jeder Schlitzgruppe, wobei die relativen Positionsinformationen einen relativen Winkel und/oder einen relativen Abstand umfassen;
Abgleichen der relativen Positionsinformationen mit einer vorbestimmten Vergleichstabelle zur Luftzufuhreffizienz, um die Daten zur Luftzufuhreffizienz jedes Ventilators zu jeder Schlitzgruppe zu erlangen;
Bilden der einspaltigen Matrix zur Luftzufuhreffizienz jedes Ventilators auf Grundlage der Daten zur Luftzufuhreffizienz des jeden Ventilators zu jeder Schlitzgruppe; und
Durchlaufen aller Ventilatoren und Bilden der Matrix zur Luftzufuhreffizienz auf Grundlage der einspaltigen Matrix zur Luftzufuhreffizienz jedes Ventilators.

9. Vorrichtung nach Anspruch 6, wobei das Modul zum Erlangen von Daten zum Luftzufuhrvolumen zu Folgendem konfiguriert ist:
Berechnen eines Verhältnisses der einspaltigen Matrix zum gesamten geforderten Luftvolumen zu der Matrix zur Luftzufuhreffizienz und Bestimmen der Daten zum Luftzufuhrvolumen jedes Ventilators gemäß dem Verhältnis.

10. Vorrichtung nach einem der Ansprüche 6-9, wobei das Modul zum Regeln einer Drehgeschwindigkeit eines Ventilators zu Folgendem konfiguriert ist:
Bestimmen eines Modells jedes Ventilators gemäß den Drehgeschwindigkeitsparameterinformationen des jeden Ventilators; Bestimmen einer Vergleichstabelle von Luftvolumen und Drehgeschwindigkeit durch das Modell jedes Ventilators, die mit dem jeden Ventilator abgeglichen wird; Bestimmen von Daten zur Drehgeschwindigkeit jedes Ventilators durch die Vergleichstabelle von Luftvolumen und Drehgeschwindigkeit gemäß den Daten zum Luftzufuhrvolumen des jeden Ventilators und den Drehgeschwindigkeitsparameterinformationen des jeden Ventilators; und
Regeln der Drehgeschwindigkeit des Ventilators gemäß den Daten zur Drehgeschwindigkeit.

11. Computerlesbares Speichermedium, das computerausführbare Anweisungen speichert, die, wenn sie auf einem Modul zum Regeln einer Drehgeschwindigkeit eines Ventilators einer Vorrichtung zum Regeln von Drehgeschwindigkeiten von Ventilatoren nach Anspruch 6 ausgeführt werden, das Verfahren zum Regeln von Drehgeschwindigkeiten von Ventilatoren nach Anspruch 1 umsetzen.

## Revendications

1. Procédé de régulation des vitesses de rotation de ventilateurs, dans lequel les ventilateurs sont conçus pour abaisser les températures de composants qui sont montés dans des fentes d'un châssis d'un dispositif de communication de manière correspondante, et les fentes sont groupées en fonction d'un mode de groupement prédéterminé pour former des groupes de fentes ; le procédé comprenant :
l'obtention (S10) de données de volume d'air total demandé de chaque groupe de fentes en fonction d'informations de paramètres de commande de température de chaque composant qui est monté dans la fente correspondante, et la formation d'une matrice à colonne unique de volume d'air total demandé sur la base des données de volume d'air total demandé de chaque groupe de fentes ;
l'obtention (S20) d'informations de paramètres de vitesse de rotation de chaque ventilateur et de données de rendement d'alimentation en air de chaque ventilateur à chaque groupe de fentes, la formation d'une matrice à colonne unique de rendement d'alimentation en air de chaque ventilateur sur la base de données de rendement d'alimentation en air de chaque ventilateur à chaque groupe de fentes, et la formation d'une matrice de rendement d'alimentation en air sur la base de la matrice à colonne unique de rendement d'alimentation en air de chaque ventilateur ;
l'obtention (S30) de données de volume d'alimentation en air de chaque ventilateur en fonction de la matrice à colonne unique de volume d'air total demandé et de la matrice de rendement d'alimentation en air ; et
la régulation (S40) de la vitesse de rotation de chaque ventilateur en fonction des données de volume d'alimentation en air de chaque ventilateur et des informations de paramètres de vitesse de rotation de chaque ventilateur.

2. Procédé selon la revendication 1, dans lequel l'obtention de données de volume d'air total demandé de chaque groupe de fentes en fonction d'informations de paramètres de commande de température de chaque composant qui est monté dans la fente correspondante, et la formation d'une matrice à colonne unique de volume d'air total demandé sur la base des données de volume d'air total demandé de chaque groupe de fentes comprend :
l'obtention de données de température de chaque composant monté dans chaque fente et de données de température d'avertissement prédéterminée, et l'obtention de données de rendement de refroidissement de volume d'air du composant ;
le calcul d'une valeur de différence entre les données de température et les données de température d'avertissement ;
lorsque la valeur de différence est supérieure à 0, la détermination de données de volume d'air demandé du composant correspondant en fonction de la valeur de différence et des données de rendement de refroidissement de volume d'air ;
pour chaque groupe de fentes, la traversée de tous les composants dans le groupe de fentes, et l'obtention de données de volume d'air demandé de chaque composant ;
l'ajout des données de volume d'air demandé de chaque composant dans le groupe de fentes pour obtenir les données de volume d'air total demandé du groupe de fentes ; et
la formation de la matrice à colonne unique de volume d'air total demandé sur la base des données de volume d'air total demandé de chaque groupe de fentes.

3. Procédé selon la revendication 1, dans lequel l'obtention de données de rendement d'alimentation en air de chaque ventilateur à chaque groupe de fentes, la formation d'une matrice à colonne unique de rendement d'alimentation en air du ventilateur sur la base de données de rendement d'alimentation en air de chaque ventilateur à chaque groupe de fentes, et la formation d'une matrice de rendement d'alimentation en air sur la base de la matrice à colonne unique de rendement d'alimentation en air de chaque ventilateur comprend :
l'obtention d'informations de position relative de chaque ventilateur et de chaque groupe de fentes, dans lequel les informations de position relative comprennent un angle relatif et/ou une distance relative ;
la mise en correspondance des informations de position relative avec une table de comparaison de rendement d'alimentation en air prédéterminé pour obtenir les données de rendement d'alimentation en air de chaque ventilateur à chaque groupe de fentes ;
la formation de la matrice à colonne unique de rendement d'alimentation en air de chaque ventilateur sur la base des données de rendement d'alimentation en air de chaque ventilateur à chaque groupe de fentes ; et
la traversée de tous les ventilateurs, et la formation de la matrice de rendement d'alimentation en air sur la base de la matrice à colonne unique de rendement d'alimentation en air de chaque ventilateur.

4. Procédé selon la revendication 1, dans lequel l'obtention de données de volume d'alimentation en air de chaque ventilateur en fonction de la matrice à colonne unique de volume d'air total demandé et de la matrice de rendement d'alimentation en air comprend :
le calcul d'un rapport de la matrice à colonne unique de volume d'air total demandé sur la matrice de rendement d'alimentation en air, et la détermination des données de volume d'alimentation en air de chaque ventilateur en fonction du rapport.

5. Procédé selon l'une quelconque des revendications 1 à 4, dans lequel la régulation de la vitesse de rotation de chaque ventilateur en fonction des données de volume d'alimentation en air de chaque ventilateur et des informations de paramètres de vitesse de rotation de chaque ventilateur comprend :
la détermination d'un modèle de chaque ventilateur en fonction des informations de paramètres de vitesse de rotation de chaque ventilateur ;
la détermination, grâce au modèle de chaque ventilateur, d'une table de comparaison de volume d'air et de vitesse de rotation qui correspond à chaque ventilateur ;
la détermination de données de vitesse de rotation de chaque ventilateur grâce à la table de comparaison de volume d'air et de vitesse de rotation en fonction des données de volume d'alimentation en air de chaque ventilateur et des informations de paramètres de vitesse de rotation de chaque ventilateur ; et
la régulation de la vitesse de rotation de chaque ventilateur en fonction des données de vitesse de rotation de chaque ventilateur.

6. Dispositif de régulation des vitesses de rotation de ventilateurs, comprenant :
un module d'obtention de matrice de volume d'air total demandé (01), conçu pour obtenir des données de volume d'air total demandé de chaque groupe de fentes en fonction d'informations de paramètres de commande de température de chaque composant qui est monté dans la fente correspondante, et former une matrice à colonne unique de volume d'air total demandé sur la base des données de volume d'air total demandé de chaque groupe de fentes ;
un module d'obtention de matrice de volume d'alimentation en air (02), conçu pour obtenir des informations de paramètres de vitesse de rotation de chaque ventilateur et de données de rendement d'alimentation en air de chaque ventilateur à chaque groupe de fentes, former une matrice à colonne unique de rendement d'alimentation en air de chaque ventilateur sur la base de données de rendement d'alimentation en air de chaque ventilateur à chaque groupe de fentes, et former une matrice de rendement d'alimentation en air sur la base de la matrice à colonne unique de rendement d'alimentation en air de chaque ventilateur ;
un module d'obtention de données de volume d'alimentation en air (03), conçu pour déterminer des données de volume d'alimentation en air de chaque ventilateur en fonction de la matrice à colonne unique de volume d'air total demandé et de la matrice de rendement d'alimentation en air ; et
un module de régulation de vitesse de rotation de ventilateur (04), conçu pour réguler une vitesse de rotation de chaque ventilateur en fonction des données de volume d'alimentation en air de chaque ventilateur et des informations de paramètres de vitesse de rotation de chaque ventilateur.

7. Dispositif selon la revendication 6, dans lequel le module d'obtention de matrice de volume d'air total demandé est conçu pour :
obtenir des données de température de chaque composant monté dans chaque fente et des données de température d'avertissement prédéterminée, et obtenir des données de rendement de refroidissement de volume d'air du composant ;
calculer une valeur de différence entre les données de température et les données de température d'avertissement ;
lorsque la valeur de différence est supérieure à 0, déterminer des données de volume d'air demandé du composant correspondant en fonction de la valeur de différence et des données de rendement de refroidissement de volume d'air ;
pour chaque groupe de fentes, traverser tous les composants dans le groupe de fentes, et obtenir les données de volume d'air demandé de chaque composant ;
ajouter les données de volume d'air demandé de chaque composant dans le groupe de fentes pour obtenir les données de volume d'air total demandé du groupe de fentes ; et
former la matrice à colonne unique de volume d'air total demandé sur la base des données de volume d'air total demandé de chaque groupe de fentes.

8. Dispositif selon la revendication 6, dans lequel le module d'obtention de matrice de volume d'alimentation en air est conçu pour :
obtenir les informations de paramètres de vitesse de rotation du ventilateur ;
obtenir les informations de position relative de chaque ventilateur et chaque groupe de fentes, dans lequel les informations de position relative comprennent un angle relatif et/ou une distance relative ;
mettre en correspondance les informations de position relative avec une table de comparaison de rendement d'alimentation en air prédéterminé pour obtenir les données de rendement d'alimentation en air de chaque ventilateur à chaque groupe de fentes ;
former la matrice à colonne unique de rendement d'alimentation en air de chaque ventilateur sur la base des données de rendement d'alimentation en air de chaque ventilateur à chaque groupe de fentes ; et
traverser tous les ventilateurs, et former la matrice de rendement d'alimentation en air sur la base de la matrice à colonne unique de rendement d'alimentation en air de chaque ventilateur.

9. Dispositif selon la revendication 6, dans lequel le module d'obtention de données de volume d'alimentation en air est conçu pour :
calculer un rapport de la matrice à colonne unique de volume d'air total demandé sur la matrice de rendement d'alimentation en air, et déterminer les données de volume d'alimentation en air de chaque ventilateur en fonction du rapport.

10. Dispositif selon l'une quelconque des revendications 6 à 9, dans lequel le module de régulation de vitesse de rotation de ventilateur est conçu pour :
déterminer un modèle de chaque ventilateur en fonction des informations de paramètres de vitesse de rotation de chaque ventilateur ; déterminer, grâce au modèle de chaque ventilateur, une table de comparaison de volume d'air et de vitesse de rotation qui correspond à chaque ventilateur ; déterminer des données de vitesse de rotation de chaque ventilateur à travers la table de comparaison de volume d'air et de vitesse de rotation en fonction des données de volume d'alimentation en air de chaque ventilateur et des informations de paramètres de vitesse de rotation de chaque ventilateur ; et
réguler la vitesse de rotation du ventilateur en fonction des données de vitesse de rotation.

11. Support de stockage lisible par ordinateur, stockant des instructions exécutables par ordinateur, qui, lorsqu'il est exécuté sur un module de régulation de vitesse de rotation de ventilateur d'un dispositif de régulation des vitesses de rotation de ventilateurs selon la revendication 6, met en œuvre le procédé de régulation des vitesses de rotation de ventilateurs selon la revendication 1.
